# EUROPEAN PATENT SPECIFICATION

(11) **EP 2 081 245 B1**
(45) Date of publication and mention of the grant of the patent: **22.09.2010**
(21) Application number: 09000512.5
(22) Date of filing: 15.01.2009
(51) Int. Cl.: H01H 13/06, H01H 13/704

(54) **Three-dimensional liquid crystal polymer multilayer circuit board including membrane switch and related manufacturing method**
Dreidimensionale Flüssigkristallpolymer-Mehrschichtleiterplatte mit Membranschalter und zugehöriges Herstellungsverfahren
Carte de circuit multicouche tridimensionnelle en polymères de cristaux liquides incluant un interrupteur à membrane et procédé de fabrication correspondant

(30) Priority: 17.01.2008 US 16075
(43) Date of publication of application: 22.07.2009
(73) Proprietor: Harris Corporation, Melbourne FL 32919 (US)
(72) Inventor: Shacklette, Lawrence Wayne, Melbourne, FL 32934-8594 (US); Rendek, Louis Joseph, Jr., West Melbourne, FL 32904-8757 (US)
(74) Representative: Schmidt, Steffen

(56) References cited:
- EP-A1- 1 087 415
- EP-A2- 1 045 413
- EP-A2- 1 081 729
- WO-A-2005/084090
- US-A1- 2002 004 167
- US-A1- 2006 104 037
- US-A1- 2007 209 920
- US-A1- 2008 003 493
- US-B2- 7 045 246

## Description

The present invention relates to the field of circuit boards, and, more particularly, to circuit boards such as those including a battery provided therein and related methods.

An electronic device may include one or more circuit boards. A typical circuit board is a two-dimensional (2D) planar board that mechanically supports electronic components. The electronic components may comprise, for example, resistors, capacitors, switches, batteries, and other more complex integrated circuit components, i.e. microprocessors. The circuit board typically comprises a dielectric material, for example, a plastic material.

The circuit board may include conductive traces on the surface for connecting the electronic components to each other. As electronic circuitry has become more complex, multilayer circuit boards with at least two electrically conductive pattern layers have been developed. Typically, the different conductive trace layers of a multilayer circuit board may be connected through vertically extending vias, which comprise conductive materials, for example, metal. A typical multilayer circuit board may comprise a plurality of core layers with bonding layers therebetween affixing the adjacent core layers together. Each core layer typically includes a dielectric layer with electrically conductive pattern layers on the opposing surfaces of the dielectric layer. Typically, during manufacture of the multilayer circuit boards, the core and bonding layers are stacked together and then heated (laminated) to cause the bonding layer to affix the adjacent core layers together.

Even with the advent of the multilayer circuit board, as the mounted circuitry has become even more complex, the size of the circuit board and associated packaging has also increased. This increase in size may pose installation drawbacks in applications where space may be limited or where fitting a planar two-dimensional circuit board may be problematic. Three-dimensional (3D) circuit boards are an approach to this drawback of typical 2D planar circuit boards. As with the typical planar multilayer circuit board, the typical 3D circuit board may comprise a plurality of core layers with bonding layers therebetween affixing adjacent layers together.

Advantageously, 3D circuit boards may perform functions beyond the traditional mechanical support and electrical connection functions of the 2D circuit board. In other words, the 3D circuit board may be a multifunctional structure. For example, the 3D circuit board may perform mechanical, aerodynamic, and encapsulation functions.

Another approach to growth in circuit board size is integrating external electronic components into the circuit board, for example, batteries, and switches. For example, U.S. Patent No. 7,045,246 to Simburger et al. discloses a thin film battery embedded in a multilayer thin film flexible circuit board. The circuit board comprises polyimide material, which may have some undesirable material characteristics.

One method to forming 3D circuit boards is disclosed in U.S. Patent Application Serial No. 11 /695,685 to Shacklette et al., also assigned to the assignee of the present invention. The method includes thermoforming core layers individually on a 3D mold structure, stacking the thermoformed core layers, and laminating the stacked thermoformed layers at even a greater temperature. One possible drawback of this method is the two-step heating and cooling process increases manufacturing time and limits productivity.

Document US 2008003493 relates to thin film batteries and discloses a method for making a thin film battery package by attaching the components of a thin film battery to a liquid crystal polymer substrate, encapsulating the thin film battery components with a liquid crystal polymer lid including at least one film getter, and substantially sealing the thin film battery components within the liquid crystal polymer substrate and liquid crystal polymer lid.

In view of the foregoing background, it is therefore an object of the present invention to provide an electronic device with a multilayer circuit board including a battery therein with effective sealing and good electrical properties.

This and other objects, features, and advantages in accordance with the present invention are provided by an electronic device including a multilayer circuit board having a non-planar three-dimensional shape defining a battery component receiving recess therein. The multilayer circuit board may include at least one pair of liquid crystal polymer (LCP) layers, and at least one electrically conductive pattern layer on at least one of the LCP layers and defining at least one battery electrode adjacent to the battery component receiving recess. The electronic device may further include a battery component within the battery component receiving recess and coupled to the at least one battery electrode to define a battery. Advantageously, the electronic device includes a battery with component receiving recess therein that is hermetically sealed and has good electrical properties.

Additionally, the electronic device may further comprise circuitry carried by the multilayer circuit board and receiving power from the battery. The multilayer circuit board may further comprise a bonding layer between the at least one pair of LCP layers. The at least one electrically conductive pattern layer may comprise at least one of copper and aluminum, for example.

In certain embodiments, the bonding layer may comprise a curable bonding layer. In other embodiments, the bonding layer may comprise a thermoplastic bonding layer. The multilayer circuit board may define exterior portions for the battery. The battery component may comprise an electrolyte, an anode, a cathode, and a spacer.

Another aspect is directed to an electronic device comprising a multilayer circuit board LCP layers, and at least one electrically conductive pattern layer on the LCP layers and defining at least one battery electrode adjacent the battery electrolyte receiving recess. The electronic device may also include a battery electrolyte within the battery electrolyte receiving recess, and circuitry carried by the multilayer circuit board and receiving power from the battery. Moreover, the battery electrolyte may comprise a lithium ion electrolyte.

Another aspect is directed to a method for making an electronic device comprising forming a multilayer circuit board having a non-planar three-dimensional shape defining a battery component receiving recess therein. The multilayer circuit board may comprise at least one pair of liquid crystal polymer (LCP) layers, and at least one electrically conductive pattern layer on at least one of the LCP layers and defining at least one battery electrode adjacent the battery component receiving recess. The method may further include positioning a battery component within the battery component receiving recess and coupled to the at least one battery electrode to define a battery.

The method may further comprise mounting circuitry on the multilayer circuit board to receive power from the battery. Additionally, the multilayer circuit board may further comprise a bonding layer between the at least one pair of LCP layers.

Moreover, the forming the multilayer circuit board may comprise forming a stacked arrangement comprising the at least one pair of LCP layers with the bonding layer therebetween. The forming of the multilayer circuit board may also comprise heating and applying pressure to the stacked arrangement to shape the stacked arrangement into a non-planar 3D shape and concurrently causing the bonding layer to bond together the adjacent LCP layers of the stacked arrangement. The forming of the stacked arrangement may comprise initially forming a stacked planar arrangement. Each of the LCP layers may have a melting temperature, and the bonding layer may have a bonding temperature less than the melting temperature of each of the LCP layers.
FIG. 1 is a flowchart illustrating a method for making a non-planar 3D multilayered circuit board according to an illustrative example, not forming part of the present invention.
FIG. 2 is a perspective view of a non-planar 3D multilayer circuit board made according to the method of FIG. 1.
FIG. 3 is a schematic cross-sectional diagram of an electronic device according to an illustrative example, not forming part of the present invention.
FIG. 4 is a flowchart illustrating a method not forming part of the invention for making the electronic device of FIG. 3.
FIGS. 5-12 illustrate an an example of the method for making the electronic device of FIG. 3
FIG. 13 is an isometric view from the top of another electronic device according to the present invention.
FIG. 14 is a second isometric view from the bottom of the electronic device of FIG. 13.
FIG. 15 is a cross-section view of the electronic device of FIG. 13.
FIG. 16 is a flowchart illustrating a method for making the electronic device of FIG. 13.

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

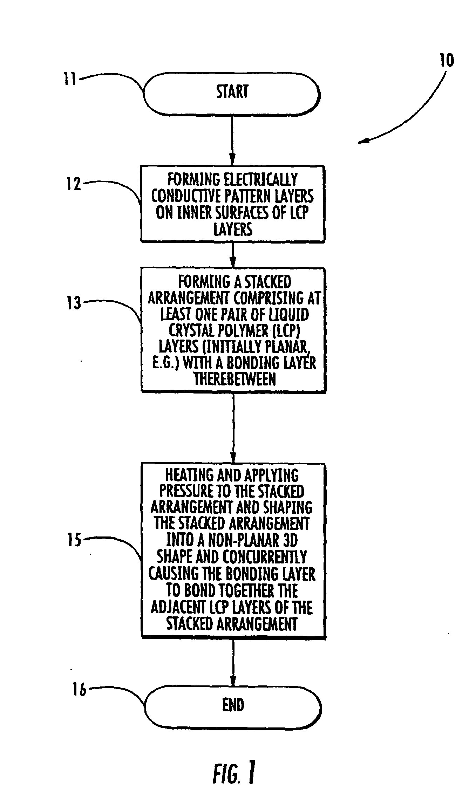

Referring initially to FIGS. 1-2, a flowchart **10** illustrates a method not forming part of the invention for making a non-planar three-dimensional (3D) multilayer circuit board **80.** From the start (Block **11**), the method illustratively includes forming (Block **12**) a electrically conductive pattern layer **83** on inner surfaces of liquid crystal polymer (LCP) layers **82, 85,** and forming (Block **13**) a stacked arrangement, which may be initially planar, the stacked arrangement comprising at least one pair of the LCP layers **82, 85** with a bonding layer **84** therebetween.

The electrically conductive pattern layer **83** is illustratively formed on each LCP layer **82, 85.** As will be appreciated by those skilled in the art, the electrically conductive pattern layer **83** may be stripped thereafter. In some embodiments, the electrically conductive pattern layer **83** may be formed on a single LCP layer **82, 85.** As will be appreciated by those skilled in the art, the multilayer circuit board **80** may be defined by the number of the electrically conductive pattern layers **83** thereon.

The LCP layers **82, 85** may comprise, for example, Rogers F/flex® 3600, 3850 core material layers or Nippon Steel Espanex L, Std-Type core material layers. Each of the LCP layers may comprise a biaxially oriented LCP layer. Advantageously, the biaxially oriented LCP layers have low values for the X and Y coefficients of thermal expansion (CTE) and relatively high values for the Z CTE. For example, Rogers F/flex® 3600 and 3850 both have X, Y, and Z values for CTE of 17 (10⁻⁶*1/°C), 17 (10⁻⁶*1/°C), and 150 (10⁻⁶*1/°C), respectively.

Advantageously, LCP has electrical properties that may helpful for use in the 3D multilayer circuit **80** board. For example, Rogers F/flex® 3600 and 3850 both have a low dielectric constant of 2.9 and a loss tangent at 10 GHz of 0.0025. Moreover, LCP (Rogers F/flex® 3600/3850 and or Nippon Steel Espanex L) has hermetic properties and a low water uptake of 0.04%, and a Young modulus of in the range of 2400-3000 MegaPascals. Advantageously, LCP provides a mechanically robust dielectric material. Moreover, the low loss tangent provides for lower losses in high frequency circuitry, and the lower dielectric constant provides the ability to reduce line spacing and create more compact circuit layouts.

The stacked arrangement illustratively includes the electrically conductive pattern layer **83,** for example, metal traces, on each of the LCP layers **82, 85.** The electrically conductive pattern layer **83** may comprise at least one of copper, nickel, silver, gold, indium, lead, tin, carbon, and aluminum or an alloy thereof. For example, the electrically conductive pattern layer **83** may comprise a base metal layer of one type and a second metal layer of a second type thereon, in other words, a multilayer composite.

The electrically conductive pattern layer **83** may be applied to some or all of the LCP layers **82, 85** before or after the thermoforming and lamination step. As will be appreciated by those skilled in the art, applying the electrically conductive pattern layer **83** to the inner surfaces of the LCP layers **82, 85** may need to be performed before the thermoforming and lamination step.

In certain 3D forms with high aspect ratios, forming the electrically conductive pattern layers **83** before the thermoforming and lamination step may be more difficult. In these high aspect ratio 3D circuit boards, the electrically conductive pattern layers **83** may be formed thereafter using, for example, inkjet printing or silk screening. As will be appreciated by those skilled in the art, the electrically conductive pattern layer **83** may comprise any material with suitable conductivity properties. Advantageously, the low value of X-Y CTE and high value of X-Y tensile modulus for the LCP layers may prevent breaks and discontinuities in the electrically conductive pattern layer **83** during the thermoforming and lamination step. Indeed, the linear (X-Y) CTE of copper is 17 (10⁻⁶* 1/°C), which advantageously matches the X-Y CTE of the LCP layers.

Further advantage stems from the thermoforming step being carried out at a temperature that is significantly below the melting point and approximately equal to or even as much as 30°C below the glass transition temperature of the LCP core layers. Under such conditions, the LCP core layers retain a modulus significantly higher than that of the bonding layer **84,** a condition that will act to limit and more uniformly spread the deformation of the LCP layers **82, 85** and the copper traces thereupon, thereby reducing the chances for a break in the copper traces **83** caused by excessive elongation.

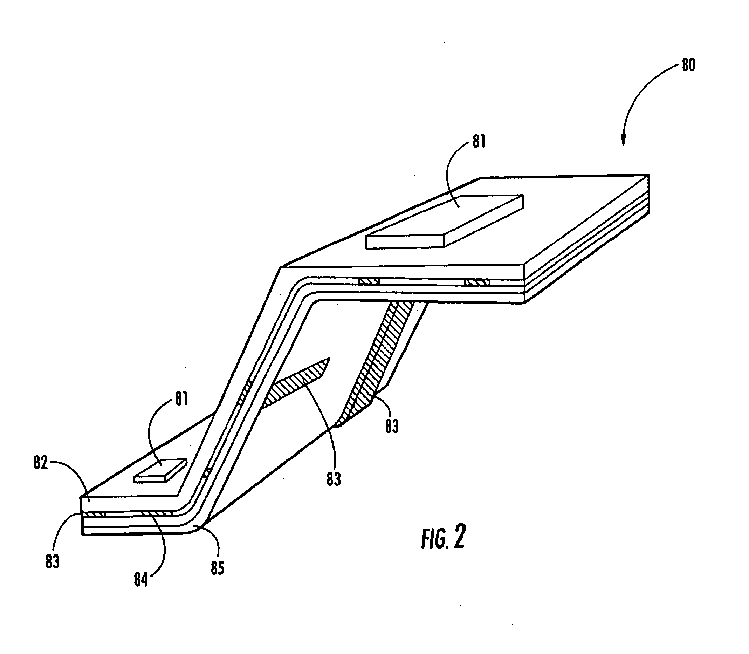

The method illustratively includes heating and applying pressure to the stacked arrangement to shape the stacked arrangement into a non-planar 3D shape and concurrently causing (Block **15**) the bonding layer **84** to bond together the adjacent LCP layers **82, 85** of the stacked arrangement to thereby form the non-planar 3D multilayer circuit board. The method ends at (Block **16**), an exemplary multilayer circuit board **80** with circuitry **81** thereon being shown in FIG. 2. In other words, the multilayer circuit board is thermoformed and laminated in one step.

Additionally, the heating (Block **15**) may comprise heating in a range of 170 to 230°C. Preferably, the heating (Block **15**) may comprise heating in a range of 180 to 220°C. As will be appreciated by those skilled in the art, the low temperature bound is determined by the respective temperature that provides adequate plasticity in the LCP layers **82, 85** for thermoforming. In other words, the LCP should be flexible enough to be shaped or have sufficient plasticity to deform under pressure or vacuum. The high temperature bound is determined by the respective temperature that generates excessive plasticity or fluidity in the LCP layers **82, 85,** thereby causing the LCP layers to excessively and/or unevenly deform during thermoforming. The high temperature limit may depend on the particular choice of LCP material, since the glass transition temperature and the melting point generally vary with the particular grade or manufacturer. It is generally preferred to perform the process at the lowest temperature that produces the desired permanent shape. A preferred temperature range is from about 180°C to 220°C. The heating (Block **15**) may further comprise increasing the temperature at a constant rate and subsequently decreasing the temperature at a constant rate, for example, 5°C per minute and 10°C per minute, respectively.

Applying pressure (Block **15**) may comprise applying pressure using at least one of a vacuum bag and a press mold, as will be appreciated by those skilled in the art. The pressure range may be 50-200 pounds per square inch (psi), for example. Preferably, the pressure range is about 80-120 psi. As will be appreciated by those skilled in the art, performing the concurrent thermoforming and lamination step at the low pressure bound may require a greater process temperature, and performing the concurrent thermoforming and lamination step at the higher pressure bound may require a lower process temperature.

Moreover, each of the LCP layers **82, 85** has a glass transition temperature and a melting temperature above the glass transition temperature. Near or above the glass transition temperature, the LCP layers **82, 85** have a plasticity value for permitting thermoforming. The bonding layer **84** has a bonding temperature that is significantly below the melting point and approximately equal to or even slightly below the glass transition temperature of the LCP layers **82, 85.** Advantageously, the steps of bonding/laminating the bonding layer and thermoforming the 3D multilayer circuit board **80** may be concurrently performed since the process temperature of the bonding layer **84** and the glass transition temperature of the LCP layers are within range.

As will be appreciated by those skilled in the art, the layers of the 3D multilayer circuit board **80** may be precisely aligned to fit circuit board features of one layer to the appropriate features in adjacent layers. For example, the layers may have alignment holes drilled in them before/after the thermoforming and lamination step, the holes being aligned with posts in the press mold to be used in either a mechanical press or within a vacuum bag subject to heat and pressure within an autoclave.

In some embodiments, the bonding layer **84** may comprise a curable bonding layer, and the bonding temperature may comprise a curing temperature for the curable bonding layer. For example, the bonding layer **84** may comprise a Bismaleimide-Triazine (BT) resin. For example, in these embodiments, the bonding layer may comprise Gore Speedboard® C/LF preimpregnated thermoset bonding layers. The process/curing temperature of the Gore Speedboard® C/LF preimpregnated thermoset bonding layers is recommended to be about 180-220°C. As will be appreciated by those skilled in the art, other curable bonding layers having a process/curing temperature within range of the glass transition temperature of LCP may be used.

In other embodiments, the bonding layer **84** may comprise a thermoplastic bonding layer, and the bonding temperature may comprise a melting temperature for the thermoplastic bonding layer. Furthermore, the bonding layer **84** may comprise, for example, a thermoplastic, such as, chlorotrifluoroethylene (CTFE). For example, in these embodiments, the thermoplastic bonding layer may comprise Arlon® 6250 bonding layers. The process/melting temperature of the Arlon® 6250 bonding layers is within the range of 120-150°C. As will be appreciated by those skilled in the art, other thermoplastic bonding layers, such as, Arlon® 6700 or Rodgers© 3001, having a process/melting temperature within range of the glass transition temperature of LCP may be used.

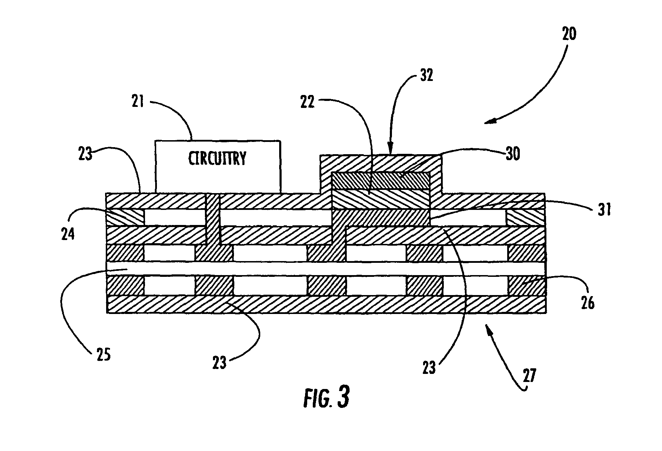

Referring now to FIG. 3, an exemplary electronic device **20** not forming part of the invention is now described. The electronic device **20** illustratively includes a multilayer circuit board **27** having a non-planar three-dimensional shape defining a battery component receiving recess **32** of the electronic device therein. The battery component receiving recess **32** may receive, for example, active materials, electrolytes **22,** spacers, an anode, a cathode, and current collectors. The LCP layers **23** may function to provide environmental packaging as well as a substrate for circuitry **21** that also comprises the electronic device **20.**

As will be appreciated by those skilled in the art, the non-planar three-dimensional shape defining a battery component receiving recess **32** therein may be manufactured using the method for making a non-planar 3D multilayered circuit board described above. Alternatively, other methods of thermoforming may be used as will also be appreciated by those skilled in the art, for example, the two step lamination and thermoforming process disclosed in U.S. Patent Application Serial No. 11/695,685 to Shacklette et al.

The multilayer circuit board **27** illustratively includes a plurality of LCP layers **23,** and a plurality of electrically conductive pattern layers **26** on some of or all of the LCP layers. The electrically conductive pattern layers **26** define a pair of battery electrodes (contracts) **31,30** adjacent the battery component receiving recess **32.** The electrically conductive pattern layers **26** may comprise at least one of copper and aluminum, for example. More specifically, the battery contacts **31, 30** include a cathode contact **30** comprising aluminum and an anode contact **31** comprising copper. As will be appreciated by those skilled in the art, other conductive metals may be used.

In some embodiments (not forming part of the invention), the multilayer circuit board may include a single LCP layer, and a metal foil layer thereon sealing the battery component receiving recess and the components contained therein. The metal foil layer may comprise, for example, gold, copper, nickel, iron, cobalt, aluminum, molybdenum, silver, zinc, titanium, and alloys thereof. Preferably, the metal foil may comprise copper, aluminum or stainless steel, or one of those metals plated or coated by a second metal.

The electronic device **20** may further include anode and cathode active materials, an insulating spacer, optional metal current collectors, and a battery electrolyte **22** within the battery component receiving recess **32.** The battery electrolyte **22** may contact the battery electrode contacts **31, 30** to define a battery, and with the multilayer circuit board **27** defining exterior portions for the battery. Moreover, the battery electrolyte **22** may comprise lithium ion electrolyte, for example.

Advantageously, the electrolyte receiving recess **32** may define the boundaries of the battery components, for example, the electrolyte **22,** the anode and cathode active materials, the insulating spacer, the metal current collectors. In other words, the bare battery electrolyte **22** and other battery components may be integrated into the multilayer circuit board **27** without the typical packaging, for example, foil packaging. In other embodiments, the battery electrolyte **22** and other battery components may be integrated into the multilayer circuit board **27** with the typical packaging. The components of the battery, such as, current collectors, electrodes, and spacers, may be stacked between the LCP layers **23** prior to lamination, and the subsequent lamination step may both form the LCP around the battery stack and both laminate the multilayer circuit board **27** and seal the battery components in one step.

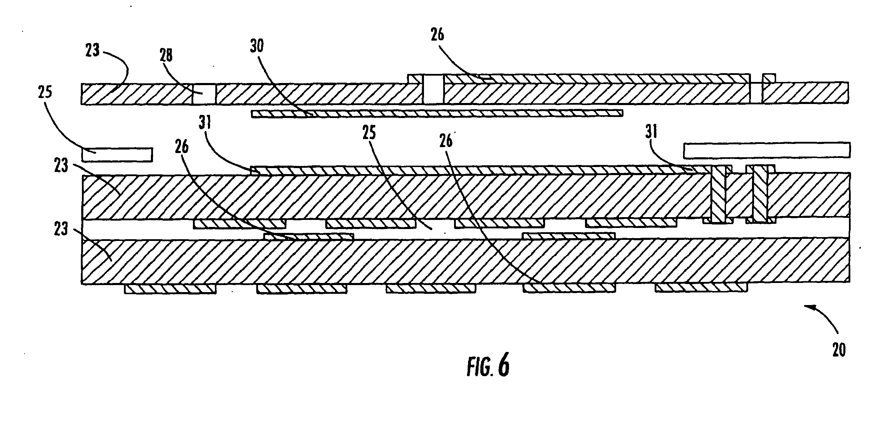

As will be appreciated by those skilled in the art, the battery electrolyte **22** may comprise other electrolyte types. Moreover, the electrolyte **22** may be inserted into the battery component receiving recess **32** after thermoforming and lamination of the LCP layers **23,** for example, using an opening **28** (FIGS. 6-12) in the battery component receiving recess. Alternatively, the electrolyte packaged cell may be used and inserted before finishing the battery component receiving recess **32.** The battery electrolyte **22** may comprise a solid electrolyte or alternatively liquid electrolyte. In embodiments of the electronic device **20** where the non-planar three-dimensional shape defining the battery component receiving recess **32** is manufactured using the method for making a non-planar 3D multilayered circuit board described above, a solid electrolyte may be use and positioned in the LCP layers **23** before lamination. As will be appreciated by those skilled in the art, the battery electrolyte **22** may be stable at the thermoforming temperature. Alternatively, if using a liquid electrolyte, the LCP layers **23** may need to be laminated prior to injection through the opening **28** of the liquid electrolyte due to the high temperature of the thermoforming process and the likely instability of the liquid electrolyte during the thermoforming process.

Additionally, the electronic device **20** illustratively includes circuitry **21** carried by the multilayer circuit board **27** and receiving power from the battery, which may be a rechargeable battery or a one-time use battery. The circuitry **21** may comprise, for example, passive components, display components, or/and active components, such as, an integrated circuit, etc. The multilayer circuit board **27** illustratively includes a bonding layer **25** between the LCP layers **23.** In certain embodiments, the bonding layer **25** may comprise a curable bonding layer. In other embodiments, the bonding layer **25** may comprise a thermoplastic bonding layer. The electronic device also includes illustratively a perimeter seal **24,** which may be the same as or different from the bonding layer **25,** but may be processed within the same temperature window that allows the lamination and the shaping of the electronic device **20.**

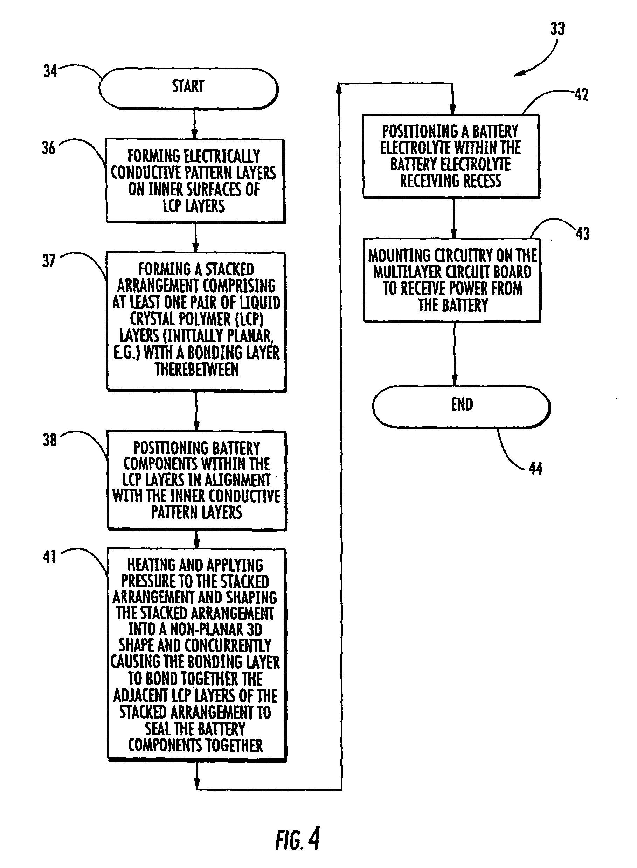

Referring now also to FIG. 4, a flowchart **33** illustrates a method not forming part of the invention for making an electronic device **20.** From the start (Block **34**), the method illustratively begins with forming electrically conductive pattern layers **26** on inner surfaces of the LCP layers **23** (Block **36**). The method also includes forming a stacked arrangement, which may be initially planar, the stacked arrangement comprising at least one pair of LCP layers **23** with a bonding layer **25** therebetween (Block **37**), and positioning battery components within the LCP layers in alignment with the inner conductive pattern layers **26** (Block **38**). The contacts of the electronic device **20** may be coated with solder or conductive adhesives, such that the, solders may melt or the adhesives may cure during the lamination and thermoforming step.

The method illustratively includes heating and applying pressure to the stacked arrangement to shape the stacked arrangement into a non-planar 3D shape and concurrently causing (Block **41**) the bonding layer **25** to bond together the adjacent LCP layers **23** of the stacked arrangement to thereby form a battery component receiving recess **32,** in other words, forming a multilayer circuit board **27** having a non-planar three-dimensional shape defining a battery component receiving recess therein. (Block **41**) The multilayer circuit board **27** includes LCP layers **23,** and a plurality of electrically conductive pattern layers **26** thereon defining a plurality of battery electrodes **30, 31** adjacent the battery component receiving recess **32.**

The method also includes positioning (Block **42**) a battery electrolyte **22** within the battery component receiving recess **32** and contacting the battery electrodes **30, 31** to define a battery for the electronic device. As will be appreciated by those skilled in the art, the battery electrolyte **22** may be inserted into the battery component receiving recess **32** further upstream, for example, by thermoforming around a prepackaged solid electrolyte cell or by including a solid or gel electrolyte among the battery components that can withstand the temperature and pressure of the lamination cycle. The method also illustratively includes mounting (Block **43**) circuitry **21** on the multilayer circuit board **27** to receive power from the battery, the method ending at (Block **44**).

In another example of the method, a non-planar 3D shape would be created during the process of (Block **41**) using appropriate tooling during this combined thermoforming and lamination step. The process step of (Block **41**) would then be followed by inserting a pre-packaged battery or full set of battery components into the battery component receiving recess **32** (Block **42**) and sealing the battery into the non-planar 3D shape by applying an additional LCP layer **23** held in place by a perimeter seal **24.** As will also be appreciated by those skilled in the art, the method described for embedding a battery can be applied to embedding similarly shaped objects, such as, a metal heat spreader or an integrated circuit.

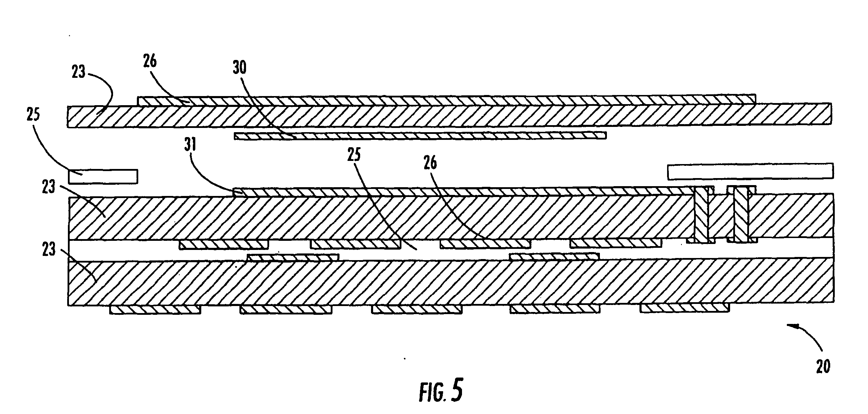

As will be appreciated by those skilled in the art, an exemplary implementation of the method of making the electronic device **20** follows. Referring additionally to FIGS. 5-12, the method is illustrated. Referring specifically to FIG. 6, the vias are formed in the top LCP layer **23,** one via forming the opening **28** for subsequent injection of a liquid electrolyte **22.**

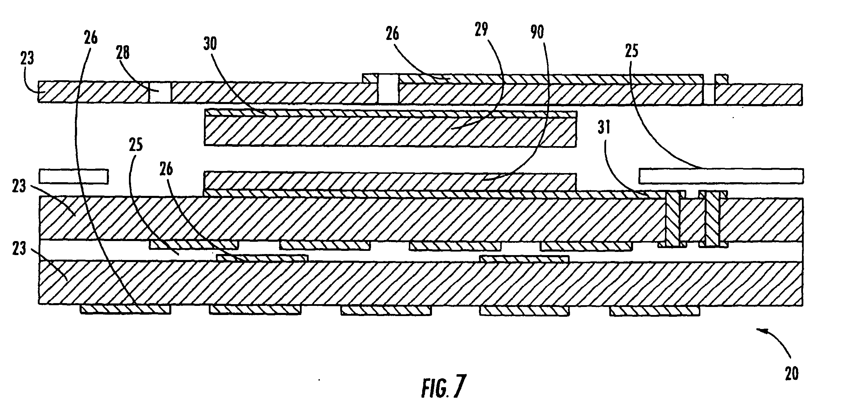

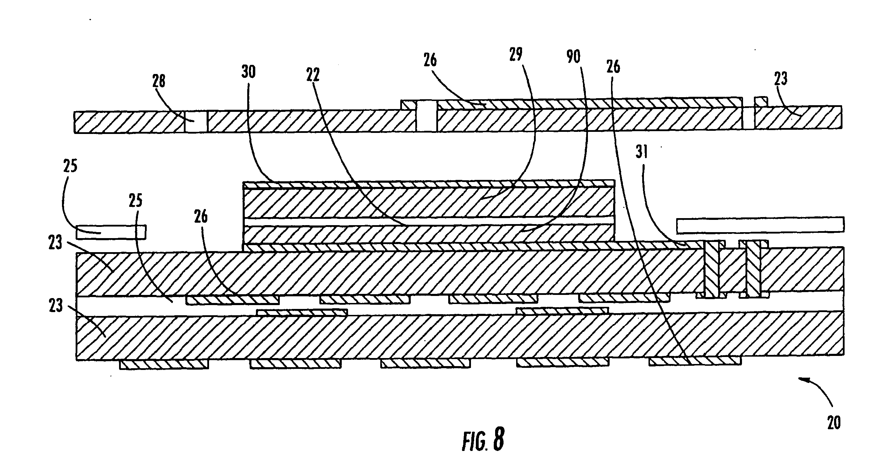

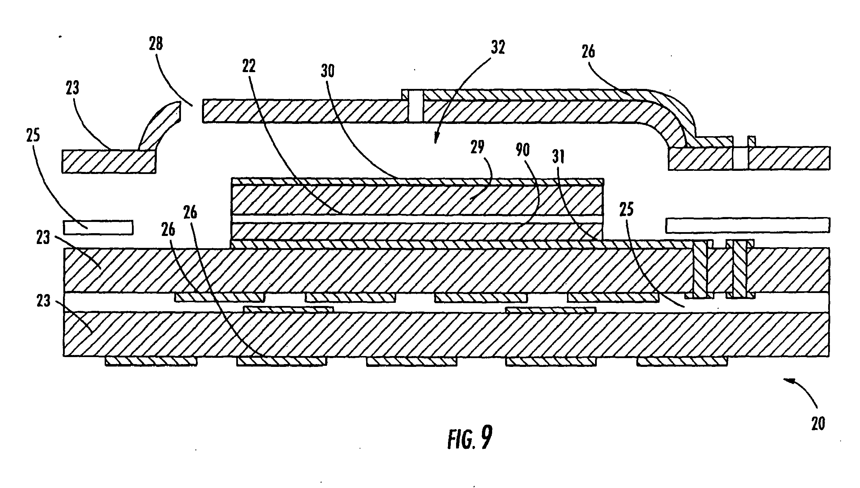

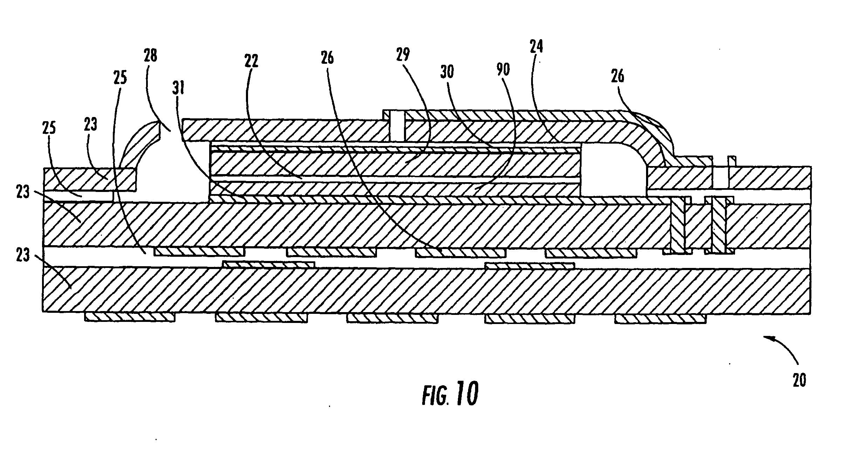

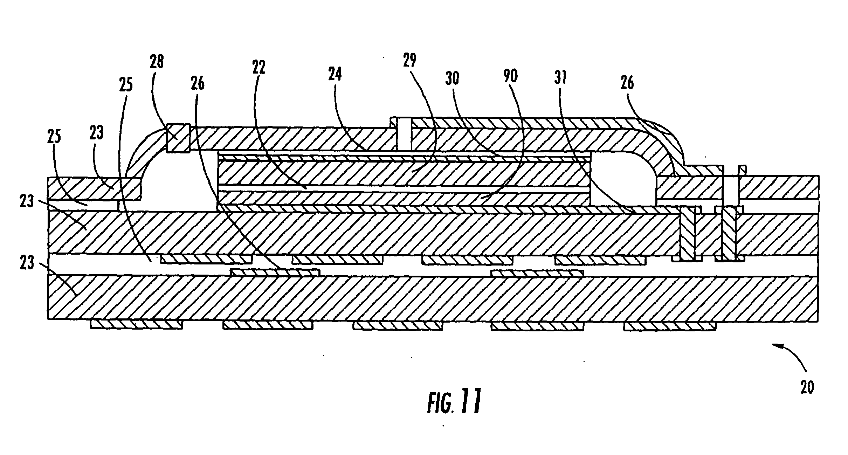

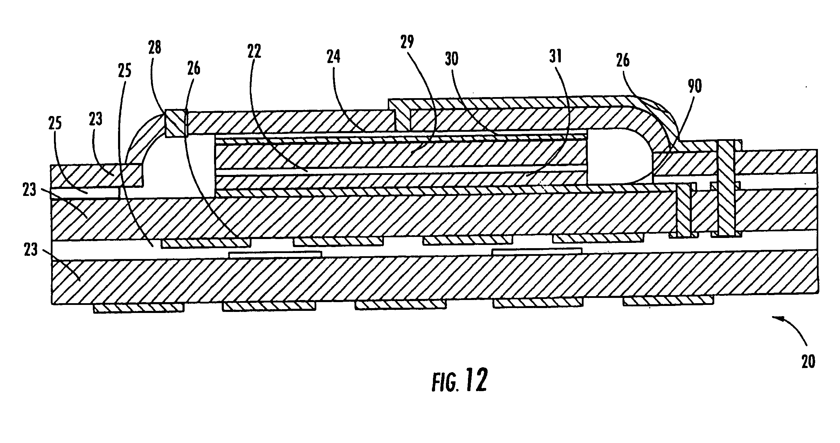

In FIG. 7, a slurry coat is applied and the cathode **30** and the anode **31** are formed out of aluminum and copper cladding, respectively. A lithium cobalt oxide electrode **29** is also formed adjacent the cathode **30.** A graphite electrode **90** is also formed respectively adjacent the anode **31.** The electrodes are then laminated (FIG. 8) and the battery is stacked-up. Referring specifically to FIG. 9, the top LCP layer **23** is thermoformed to form the battery component receiving recess **32.** Referring specifically to FIG. 10, the perimeter seal **24** is laminated on the cathode **30.** In FIG. 11, the electrolyte **22,** for example, a liquid free gel-polymer electrolyte layer, is filled post thermoforming. The opening is also filled **28** to provide a seal. In FIG. 12, the vias are either hand painted or plated to tie in battery power.

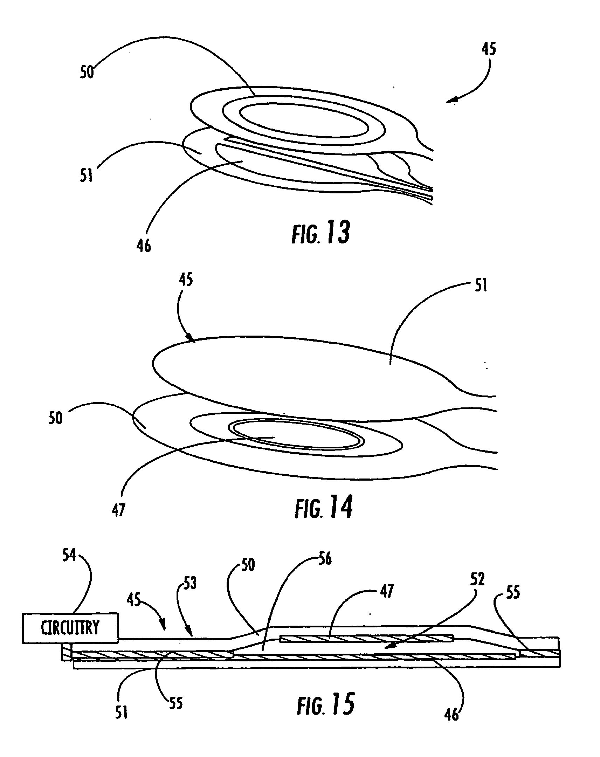

Referring now to FIGS. 13-15, an exemplary electronic device **45** is illustrated and illustratively includes a multilayer circuit board **53** having a non-planar three-dimensional shape. The non-planar three-dimensional shape defines a membrane switch recess **52** therein. As will be appreciated by those skilled in the art, the non-planar three-dimensional shape defining the membrane switch recess **52** therein may be manufactured using the method for making a non-planar 3D multilayered circuit board described above. Alternatively, other methods of thermoforming may be used as will also be appreciated by those skilled in the art, for example, the two step lamination and thermoforming process disclosed in U.S. Patent Application Serial No. 11/695,685 to Shacklette et al.

The multilayer circuit board **53** illustratively includes a pair of LCP layers **50, 51,** and a pair of conductive pattern layers **46, 47** thereon defining a plurality of membrane switch electrodes adjacent the membrane switch recess **52** to define a membrane switch. Advantageously, although typical membrane switch electrodes are plated in gold or nickel to prevent corrosion, since the thermoformed LCP layers **50, 51** provide hermetic or near hermetic properties, the membrane switch electrodes may comprise bare copper with no plating, thereby reducing manufacturing cost and durability.

The electrically conductive pattern layers **46, 47** may comprise at least one of copper, nickel, silver, gold, indium, lead, tin, carbon, and aluminum or an alloy thereof. For example, the electrically conductive pattern layers **46, 47** may comprise a base metal layer of one type and a second metal layer of a second type thereon, in other words, a multilayer composite.

Since it may be helpful to keep the membrane switch recess **52** open during the thermoforming and lamination step, it may be preferred that the lamination be made with a mechanical press that includes a top plate or tooling piece that is machined to produce the desired 3D form of the LCP layer **50.** It may be further preferred that the top plate or tool exert a vacuum on the top surface of the LCP layer **50** to ensure that it conforms to the shape of the tooling during the forming and lamination step.

The electronic device **45** may further include a compressible dielectric material filling the membrane switch recess **52.** For example, the dielectric filling material may comprise an air pocket. The electronic device **45** may also include at least one spring member **56** within the membrane switch recess **52.** Alternatively, certain embodiments may omit the spring member **56** since the thermoformed LCP layers **50, 51** are mechanically elastic and resilient and may return to preformed 3D shape after the membrane switch recess **52** is depressed.

Additionally, the electronic device **45** illustratively includes circuitry **54** carried by the multilayer circuit board **53** and being coupled to the membrane switch. Advantageously, the membrane switch may be coupled to and control the circuitry **54** integrated on the multilayer circuit board **53.** The multilayer circuit board **53** includes a bonding layer **55** between the LCP layers **50, 51.**

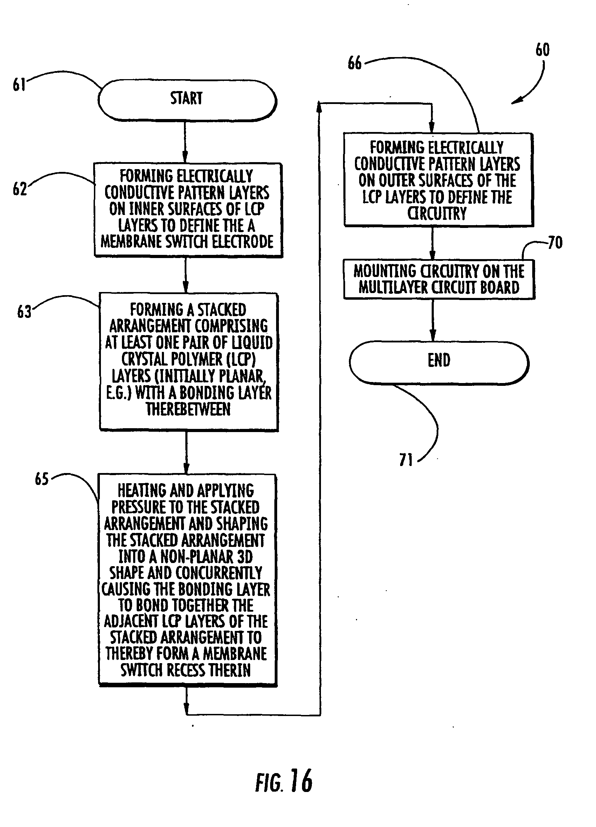

Referring now additionally to FIG. 16, a flowchart **60** illustrates a method for making an electronic device **45.** From the start (Block **61),** the method illustratively begins with forming electrically conductive pattern layers **46, 47** on inner surfaces of LCP layers **50, 51** to define at least one pair of switch electrodes (Block **62**). The method also includes forming a stacked, arrangement, which may be initially planar, the stacked arrangement comprising at least one pair of patterned LCP layers **50, 51** with a bonding layer **55** therebetween (Block **63**). The stacked arrangement includes at least one electrically conductive pattern layer **46, 47** on each of the LCP layers **50, 51.**

The method also includes heating and applying pressure and a selective vacuum to the stacked arrangement, and shaping (Block **65**) the stacked arrangement into a non-planar 3D shape and concurrently causing the bonding layer **55** to bond together the adjacent LCP layers **50, 51** of the stacked arrangement to thereby form the 3D multilayer circuit board **53.** In other words, the method includes forming a multilayer circuit board **53** having a non-planar three-dimensional shape defining a membrane switch recess **52** therein.

The method illustratively includes forming (Block **66**) electrically conductive pattern layers **46, 47** on at least one of the outer surfaces of the LCP layers **50, 51** for defining at least one membrane switch electrode adjacent the membrane switch recess **52** to define a membrane switch, i.e. to complete the circuit interconnects and optionally to connect to any surface mount components or circuitry **54.** As will be appreciated by those skilled in the art, the electrically conductive pattern layers **46, 47** may be formed further upstream in the method, for example, during the process at Block **62.** Moreover, the method illustratively includes mounting the circuitry **54** (Block **70**) on the multilayer circuit board **53,** the circuitry being coupled to the membrane switch. The method ends at (Block **71**).

## Claims

1. An electronic device comprising:
a multilayer circuit board (53) having a non-planar three-dimensional shape defining a membrane switch recess (52) therein;
said multilayer circuit board comprising at least one pair of liquid crystal polymer (LCP) layers (50, 51), and at least one electrically conductive pattern layer (46, 47) on each of the LCP layers (50, 51) and defining a plurality of membrane switch electrodes adjacent the membrane switch recess; and
a membrane switch within the membrane switch recess and coupled to said at least one membrane switch electrode to define a membrane switch.

2. The electronic device according to Claim 1 further comprising circuitry (54) carried by said multilayer circuit board (53) and coupled to the membrane switch.

3. The electronic device according to Claim 1 wherein said multilayer circuit board (53) further comprises a bonding layer (55) between the at least one pair of LCP layers (50, 51).

4. The electronic device according to Claim 3 wherein said bonding layer (55) comprises a curable bonding layer.

5. The electronic device according to Claim 3 wherein said bonding layer (55) comprises a thermoplastic bonding layer.

6. The electronic device according to Claim 1 wherein said multilayer circuit board (53) defines exterior portions for the membrane switch.

7. The electronic device according to Claim 1 wherein said at least one conductive pattern layer (46, 47) comprises at least one of copper, nickel, silver, gold, indium, lead, tin, carbon and aluminum or alloy thereof.

8. A method for making an electronic device comprising:
forming a multilayer circuit board (53) having a non-planar three-dimensional shape defining a membrane switch recess therein, by
forming at least one electrically conductive pattern layer (46, 47) on each of at least one pair of liquid crystal polymer (LCP) layers (50, 51), and
defining a plurality of membrane switch electrodes adjacent the membrane switch recess; and
forming a stacked arrangement comprising at least one pair of patterned liquid crystal polymer (LCP) layers (50, 51); and
positioning a membrane switch within the membrane switch recess and coupled to at least one of the membrane switch electrodes to define a membrane switch of the electronic device.

9. The method according to Claim 8 wherein the multilayer circuit board (53) further comprises a bonding layer (55) between the at least one pair of LCP layers (50, 51).

10. The method according to Claim 9 wherein forming the multilayer circuit board (53) comprises:
heating and applying pressure to the stacked arrangement to shape the stacked arrangement into the non-planar three-dimensional shape and concurrently causing the bonding layer (55) to bond together the adjacent LCP layers (50, 51) of the stacked arrangement.

## Patentansprüche

1. Elektronische Vorrichtung, aufweisend:
eine Mehrschichtleiterplatte (53) mit einer nichtplanaren dreidimensionalen Form, die eine Membranschalterausnehmung (52) darin definiert;
wobei die Mehrschichtleiterplatte zumindest ein Paar von Flüssigkristallpolymer-; LCP-; Schichten (50, 51) aufweist sowie zumindest eine elektrisch leitfähige bemusterte Schicht (46, 47) auf jeder der LCP-Schichten (50, 51) und eine Vielzahl von Membranschalterelektroden benachbart zu der Membranschalteraussparung definiert; und
einen Membranschalter in der Membranschalterausnehmung und zwar gekoppelt mit der zumindest einen Membranschalterelektrode, um einen Membranschalter zu definieren.

2. Elektronische Vorrichtung nach Anspruch 1, ferner aufweisend eine Schaltung (54), die von der Mehrschichtleiterplatte (53) getragen wird und mit dem Membranschalter gekoppelt ist.

3. Elektronische Vorrichtung nach Anspruch 1, bei der die Mehrschichtleiterplatte (53) ferner eine Haftschicht (55) zwischen dem zumindest einen Paar von LCP-Schichten (50, 51) aufweist.

4. Elektronische Vorrichtung nach Anspruch 3, bei der die Haftschicht (55) eine aushärtbare Haftschicht aufweist.

5. Elektronische Vorrichtung nach Anspruch 3, bei der die Haftschicht (55) eine thermoplastische Haftschicht aufweist.

6. Elektronische Vorrichtung nach Anspruch 1, bei dem die Mehrschichtleiterplatte (53) äußere Bereiche für den Membranschalter definiert.

7. Elektronische Vorrichtung nach Anspruch 1, bei dem die zumindest eine leitfähige bemusterte Schicht (46, 47) Kupfer, Nickel, Silber, Gold, Indium, Blei, Zinn, Kohlenstoff und/oder Aluminium oder eine Legierung daraus aufweist.

8. Verfahren zum Herstellen einer elektronischen Vorrichtung, aufweisend:
Bilden einer Mehrschichtleiterplatte (53) mit einer nichtplanaren dreidimensionalen Form, die eine Membranschalterausnehmung darin definiert, mittels
Bildens zumindest einer elektrisch leitfähige bemusterte Schicht (46, 47) auf jedem des zumindest einen Paars von Flüssigkristallpolymer-; LCP-; Schichten (50, 51) und
Definierens einer Vielzahl von Membranschalterelektroden benachbart zu der Membranschalterausnehmung;
Bildens einer gestapelten Anordnung, aufweisend zumindest ein Paar von bemusterten Flüssigkristallpolymer-; LCP-; Schichten (50, 51); und
Positionierens eines Membranschalters in der Membranschalterausnehmung und zwar gekoppelt mit zumindest einer der Membranschalterelektroden, um einen Membranschalter der elektronischen Vorrichtung zu definieren.

9. Verfahren nach Anspruch 8, bei dem die Mehrschichtleiterplatte (53) ferner eine Haftschicht (55) zwischen dem zumindest einen Paar von LCP-Schichten (50, 51) aufweist.

10. Verfahren nach Anspruch 9, bei dem ein Bilden der Mehrschichtleiterplatte (53) aufweist:
Erwärmen und Aufbringen eines Drucks auf die gestapelte Anordnung, um die gestapelte Anordnung in die nichtplanare dreidimensionale Form zu bringen und um gleichzeitig zu bewirken, dass die Haftschicht (55) die benachbarten LCP-Schichten (50, 51) der gestapelten Anordnung zusammen verbindet.

## Revendications

1. Dispositif électronique comprenant :
une carte de circuit imprimé multicouche (53) ayant une forme tridimensionnelle non plane définissant un renfoncement de commutateur à membrane (52) dans celle-ci ;
ladite carte de circuit imprimé multicouche comprenant au moins une paire de couches (50, 51) de polymère à cristaux liquides (PCL) et au moins une couche de tracé électriquement conductrice (46, 47) sur chacune des couches (50, 51) de PCL et définissant une pluralité d'électrodes de commutateur à membrane adjacentes au renfoncement de commutateur à membrane ; et
un commutateur à membrane à l'intérieur du renfoncement de commutateur à membrane et couplé à ladite au moins une électrode de commutateur à membrane pour définir un commutateur à membrane.

2. Dispositif électronique selon la revendication 1 comprenant en outre un circuit (54) supporté par ladite carte de circuit imprimé multicouche (53) et couplé au commutateur à membrane.

3. Dispositif électronique selon la revendication 1, dans lequel ladite carte de circuit imprimé multicouche (53) comprend en outre une couche de liaison (55) entre l'au moins une paire de couches (50, 51) de PCL.

4. Dispositif électronique selon la revendication 3, dans lequel ladite couche de liaison (55) comprend une couche de liaison durcissable.

5. Dispositif électronique selon la revendication 3, dans lequel ladite couche de liaison (55) comprend une couche de liaison thermoplastique.

6. Dispositif électronique selon la revendication 1, dans lequel ladite carte de circuit imprimé multicouche (53) définit des parties extérieures pour le commutateur à membrane.

7. Dispositif électronique selon la revendication 1, dans lequel ladite au moins une couche de tracé conductrice (46, 47) comprend au moins l'un du cuivre, du nickel, de l'argent, de l'or, de l'indium, du plomb, de l'étain, du carbone et de l'aluminium ou d'un alliage de ceux-ci.

8. Procédé de fabrication d'un dispositif électronique comprenant :
la formation d'une carte de circuit imprimé multicouche (53) ayant une forme tridimensionnelle non plane définissant un renfoncement de commutateur à membrane dans celle-ci, par
la formation d'au moins une couche de tracé électriquement conductrice (46, 47) sur chacune d'au moins une paire de couches (50, 51) de polymère à cristaux liquides (PCL), et
la définition d'une pluralité d'électrodes de commutateur à membrane adjacentes au renfoncement de commutateur à membrane ; et
la formation d'un agencement empilé comprenant au moins une paire de couches (50, 51) tracées de polymère à cristaux liquides (PCL) ; et
le positionnement d'un commutateur à membrane à l'intérieur du renfoncement de commutateur à membrane et couplé à au moins une des électrodes de commutateur à membrane pour définir un commutateur à membrane du dispositif électronique.

9. Procédé selon la revendication 8, dans lequel ladite carte de circuit imprimé multicouche (53) comprend en outre une couche de liaison (55) entre l'au moins une paire de couches (50, 51) de PCL.

10. Procédé selon la revendication 9, dans lequel la formation de la carte de circuit imprimé multicouche (53) comprend :
le chauffage et l'application d'une pression à l'agencement empilé pour mettre en forme l'agencement empilé à la forme tridimensionnelle non plane et en même temps faire en sorte que la couche de liaison (55) lie ensemble les couches (50, 51) de PCL adjacentes de l'agencement empilé.
